Europäisches Patentamt

European Patent Office

Office européen des brevets

(19)

(11) Veröffentlichungsnummer: **0 222 219**
**B1**

(12) **EUROPÄISCHE PATENTSCHRIFT**

(45) Veröffentlichungstag der Patentschrift: 11.04.90

(51) Int. Cl.⁵: **H 01 J 37/30, H 01 J 37/302**

(21) Anmeldenummer: 86114642.1

(22) Anmeldetag: 22.10.86

(54) Einrichtung, bei der ein Elektronenstrahl auf ein Medium trifft.

(30) Priorität: 02.11.85 DE 3538857

(43) Veröffentlichungstag der Anmeldung:
20.05.87 Patentblatt 87/21

(45) Bekanntmachung des Hinweises auf die
Patenterteilung:
11.04.90 Patentblatt 90/15

(84) Benannte Vertragsstaaten:
CH DE FR GB IT LI

(56) Entgegenhaltungen:
EP-A-0 030 347
DE-A-1 282 811
DE-A-2 812 285
DE-A-3 330 092
DE-B-1 299 498

(73) Patentinhaber: LEYBOLD
AKTIENGESELLSCHAFT
Wilhelm-Rohn-Strasse 25
D-6450 Hanau am Main 1 (DE)

(72) Erfinder: Bauer, Volker
Ravolzhäuser Strasse 5
D-6451 Neuberg (DE)
Erfinder: Heimerl, Josef
Sudetenring 1
D-6464 Linsengericht-1 (DE)
Erfinder: Ranke, Horst, Dr.
Brentanostrasse
D-8755 Alzenau (DE)

(74) Vertreter: Schickedanz, Willi, Dipl.-Ing.
Langener Strasse 68
D-6050 Offenbach/Main (DE)

## Beschreibung

Die Erfindung betrifft eine Einrichtung, bei der ein Elektronenstrahl auf ein Medium trifft, das sich in einem Tiegel befindet, wobei die Konturen des Tiegels auf einem Bildschirm abgebildet sind.

Bei der Erwärmung, beim Schmelzen oder beim Verdampfen von metallischen oder anderen Materialien werden oft energiereiche Elektronenstrahlen eingesetzt, die auf das zu erwärmende, zu schmelzende oder zu verdampfende Material auftreffen. Hierbei ist es meistens erforderlich, den Elektronenstrahl in vorgegebene Positionen zu bringen, um das angestrebte Ziel zu erreichen.

Für die Positionierung eines Elektronenstrahls wird die Wirkung elektrischer oder magnetischer Felder herangezogen, deren Änderung auch eine Änderung der Lage des Elektronenstrahls zur Folge hat. Besonders vorteilhaft und gebräuchlich ist die Positionierung mittels einstellbarer Ströme, die ihrerseits ein ablenkendes Magnetfeld aufbauen. Die Einstellung wird hierbei im allgemeinen mit der Hand durchgeführt, wobei eine Bedienungsperson durch ein Fenster den Elektronenstrahl beobachtet und über zwei Potentiometer die für die x- und die y-Position erforderlichen Ströme einstellt.

Wenn innerhalb eines Tiegels nacheinander mehrere Punkte des Mediums mit dem Elektronenstrahl beaufschlagt werden sollen, ist die manuelle Einstellung sehr zeitraubend. Dies gilt umso mehr, wenn der Elektronenstrahl an den verschiedenen Stellen jeweils unterschiedliche Verweilzeiten haben soll.

Solche unterschiedlichen Verweilzeiten sind für bestimmte Anwendungsfälle erforderlich, z.B. wenn mehrere Dampfquellen auf der Oberfläche des Inhalts eines einzigen Verdampfertiegels dadurch gebildet werden sollen, daß ein Elektronenstrahl in bestimmten Flächenmuster auf die Oberfläche des Tiegelinhalts geschossen wird (DE—A—28 12 285). Um bei einer derartigen Einrichtung die Leistungszufuhr durch den Elektronenstrahl auf einfache Weise vorgeben zu können, ist es bereits bekannt, diese Leistungszufuhr in Form eines Balkendiagramms auf einem Bildschirm darzustellen (DE—A—33 30 092), wobei die Balken des Balkendiagramms mit Hilfe eines Lichtgriffels verändert werden können. Der Einsatz eines Bildschirms erfolgt hierbei jedoch nicht für die Darstellung bestimmter Koordinaten in der Ebene oder im Raum.

Lichtgriffel in Verbindung mit Bildschirmen sind allgemein bekannt (Elektronik Information, Nr. 1, 1981, S. 14; IBM Technical Disclosure Bulletin, Vol. 27, No. 11, April 1985, S. 6537—6539; IBM Technical Disclosure Bulletin, Vol. 26, No. 31, August 1983, S. 1154, 1155), doch wurden sie bisher nicht für die Elektronenstrahl-Positionierung verwendet. Entsprechendes gilt für die allgemein bekannte Darstellung von Konturen von Landschaften (vergl. DE—C—29 19 419).

Schließlich ist auch noch eine Einrichtung bekannt, bei der ein Elektronenstrahl auf ein Medium trifft, das sich in einem Tiegel befindet, wobei die Konturen des Tiegels auf einem Bildschirm abgebildet sind (GB—A—11 34 416). Bei dieser Einrichtung kommt jedoch kein Lichtgriffel zur Anwendung.

Der Erfindung liegt deshalb die Aufgabe zugrunde, bei einer Einrichtung der vorstehend genannten Art verschiedene Soll-Positionen eines Elektronenstrahls auf der Oberfläche eines Mediums auf einfache Weise vorzugeben und diese Soll-Positionen automatisch und nacheinander mittels des Elektronenstrahls anzusteuern.

Diese Aufgabe wird dadurch gelöst, daß für die Festlegung einer oder mehrerer Positions-Sollwerte für die Auftreffpunkte des Elektronenstrahls innerhalb der Konturen des Tiegels ein Lichtgriffel vorgesehen ist.

Der mit der Erfindung erzielte Vorteil besteht insbesondere darin, daß mit nur einem Elektronenstrahl verschiedene Punkte auf der Oberfläche eines in einem Tiegel befindlichen Materials automatisch und exakt angesteuert werden können, und zwar unter Berücksichtigung verschiedener Verweilzeiten an den einzelnen Punkten.

Die Umlaufzeit des Elektronenstrahls, d.h. diejenige Zeit, die er benötigt, um dabei wieder an den Ausgangspunkt zu gelangen, ist hierbei extrem kurz.

Ein Ausführungsbeispiel der Erfindung ist in der Zeichnung dargestellt und wird im folgenden näher beschrieben.

Es zeigen:

Fig. 1 einen Tiegel mit einer über dem Tiegel angeordneten Elektronenkanone;

Fig. 2 eine vergrößerte Draufsicht auf den Tiegel;

Fig. 3 eine Prinzipdarstellung der erfindungsgemäßen Anordnung;

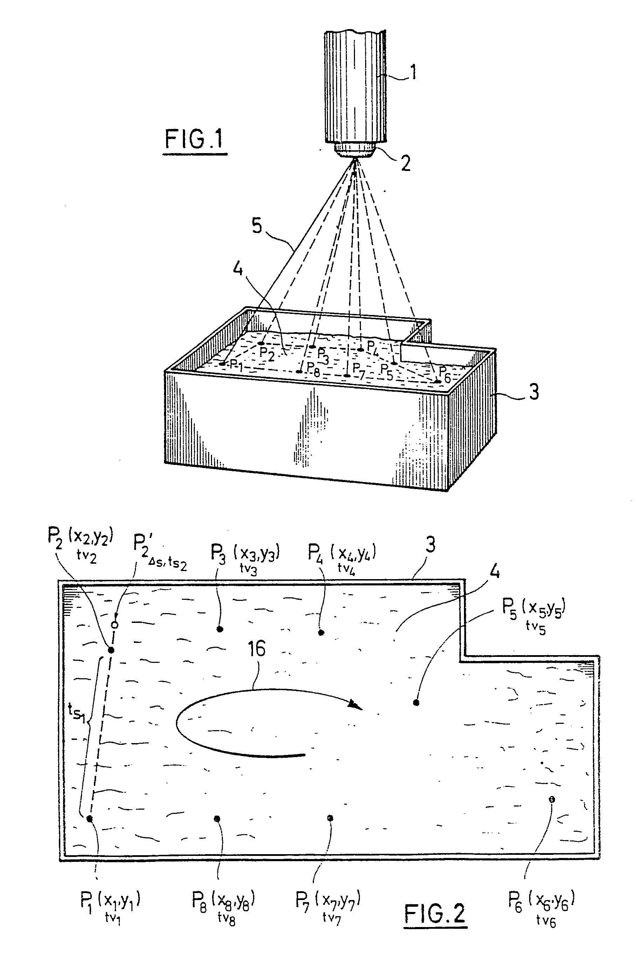

In der Fig. 1 ist eine Elektronenstrahlkanone 1 mit einem Ablenksystem 2 über einem Tiegel 3 dargestellt. In diesem Tiegel 3 befindet sich ein Medium 4, das mittels eines Elektronenstrahls 5 erwärmt wird. Der Elektronenstrahl 5 soll dabei nacheinander in die Punkte $P_1, P_2 \ldots P_8$ gesteuert werden und den Zyklus $P_1 \ldots P_8$ mehrfach hintereinander durchlaufen.

Die Fig. 2 zeigt den Tiegel noch einmal in der Draufsicht, und zwar in vergrößertem Maßstab. Man erkennt hierbei wieder die Punkte $P_1 \ldots P_8$, die vom Elektronenstrahl nacheinander anzusteuern sind. Neben diesen Punkten sind die zugehörigen x,y-Koordinaten, z.B. $x_1, y_1$ angegeben, um auszudrücken, daß diese mittels dem x-y-Ablenksystem 2 angesteuert werden. Außerdem weist jeder Punkt $P_1 \ldots P_8$ eine Angabe über die jeweilige Verweilzeit des Elektronenstrahls 5 auf. Wird der Elektronenstrahl $P_1$ nach $P_2$ bewegt, so wird er allein aufgrund eines Ortsbefehls $x_2, y_2$ nach $P_2$ gesteuert, d.h. auf das x-y-Ablenksystem 2 werden Ströme $I_x, I_y$ gegeben, die den Elektronenstrahl 5 nahezu schlagartig nach $P_2$ steuern; die Zeit $t_{s1}$, die der Elektronenstrahl 5 für den Weg zwischen $P_1$ und $P_2$ benötigt, wird praktisch nur durch die Induktivitäten des Ablenksystems 2 begrenzt. Durch die Vorgabe der Ströme $I_x, I_y$ wird

der Elektronenstrahl 5 indessen nicht ganz präzise in den Punkt $P_2$ gesteuert, sondern er wird beispielsweise bei $P_2'$ ankommen. Hierdurch entsteht ein Fehler ΔS. Dieser Fehler ΔS wird mit Hilfe einer Soll-Istwert-Regelung ausgeglichen, d.h. der Strahl 5 wird exakt in den Punkt $P_2$ gefahren.

Es findet somit keine kontinuierliche Regelung der Strahlführung von $P_1$ nach $P_2$ statt, sondern der Strahl 5 wird zunächst direkt nach $P_2$ gesteuert und dann erst bezüglich der kleinen Abweichung ΔS geregelt. Die Regelungszeit ist hierdurch kürzer.

Derselbe Vorgang spielt sich nun auch bei der Bewegung des Strahls von $P_2$ nach $P_3$, von $P_3$ nach $P_4$ usw. ab.

Während des ersten Umlaufs des Elektronenstrahls 5 von $P_1$ nach $P_8$ entsprechen die Verweilzeiten $t_{v1}$, $t_{v2}$ ... bei $P_2$, $P_3$ etc. noch nicht den endgültigen Verweilzeiten, sondern sie betragen beispielsweise das 10000-fache.

Während des zweiten Umlaufs des Elektronenstrahls 5 betragen die Verweilzeiten $t_{v1}$, $t_{v2}$ ... $t_{v8}$ nur noch das 1000-fache des richtigen Sollwerts usw., bis schließlich die Elektronenstrahl-Sollposition mit den tatsächlichen Verweilzeiten durchlaufen werden.

Durch diese Maßnahme wird erreicht, daß bei jedem Durchlauf des Elektronenstrahls 5 durch die Soll-Positionen $P_1$, $P_1$, $P_2$, $P_3$ ... $P_8$ nur kleine Korrekturen der zugehörigen Stromwerte notwendig sind.

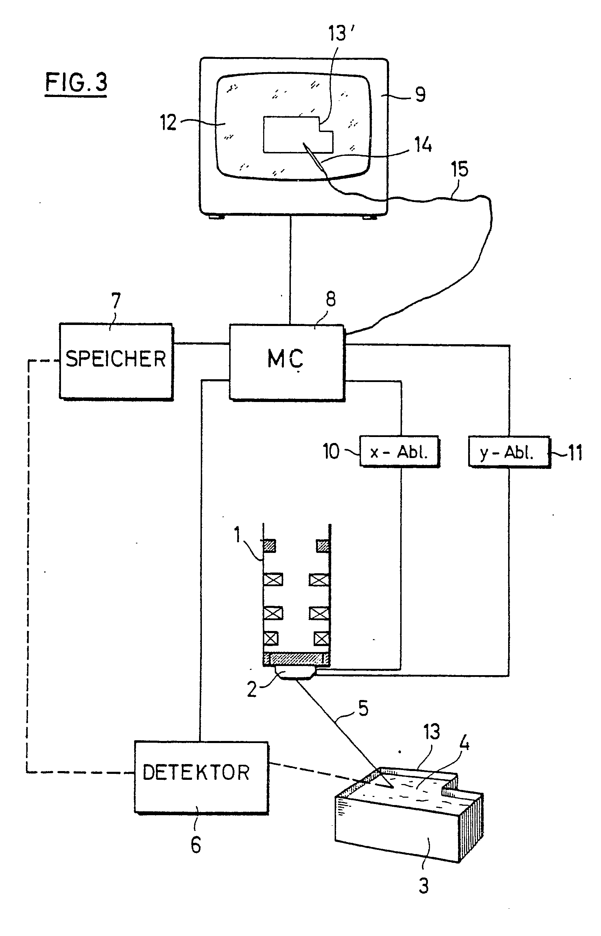

In der Fig. 3 ist eine Prinzipdarstellung der Erfindung gezeigt, in der man wieder die Elektronenstrahlkanone 1 mit dem Ablenksystem 2 erkennt. Unterhalb der Elektronenstrahlkanone 1 ist der Tiegel 3 angeordnet, dessen Inhalt 4 von dem Elektronenstrahl 5 getroffen wird. Neben dem Tiegel 3 ist ein Ist-Positionserkenner oder Detektor 6 vorgesehen, der den Auftreffpunkt des Elektronenstrahls 5 erfaßt. Bei diesem Detektor 6 kann es sich um einen Röntgenstrahldetektor handeln, wie er in der deutschen Patentanmeldung P 34 42 207.2 beschrieben ist.

Von diesem Detektor 6 führt eine Verbindung zu einem Speicher 7 und zu einem Mikrocomputer 8, der seinerseits mit einem Monitor 9 und einer x-Ablenkung 10 sowie mit einer y-Ablenkung 11 in Verbindung steht. Diese x/y-Ablenkungen 10, 11 sind mit dem Ablenksystem 2 verbunden.

Der Monitor 9 weist einen Bildschirm 12 auf, der den Tiegelrand 13 als Kontur 13′ abbildet. Mit Hilfe eines Lichtgriffels 14, der über die Leitung 15 gespeist wird, können innerhalb der Kontur 13′ Sollwert-Positionen eingegeben werden.

Dieser Lichtgriffel besitzt an seinem vorderen Ende einen Sensor, mit dem das Auftreffen eines Elektronenstrahls des Monitors 9 erfaßt werden kann. Soll der Elektronenstrahl 5 in eine bestimmte Soll-Position innerhalb des Tiegelrands 13 gebracht werden, so ist es möglich, diese Soll-Position innerhalb der Abbildung 13′ des Tiegelrands 13 mit der Spitze des Lichtgriffels 14 zu bezeichnen.

Diese Spitze wird auf die bestimmte Soll-Position gesetzt und erhält aufgrund der zeilenförmigen Abtastung des Bildschirms 12 durch einen nicht dargestellten Elektronenstrahl des Monitors 9 in kurzen aufeinanderfolgenden Abständen einen Impuls. Diesen Impuls gibt der Lichtgriffel 14 an den Mikrocomputer 8. In dem Mikrocomputer kann nun die Position der Spitze des Lichtgriffels 14 innerhalb des Rands 13′ genau erfaßt werden. Die von dem Lichtgriffel 14 abgegebenen Impulse definieren den Zeitpunkt, zu dem der Elektronenstrahl des Monitors 9 auf die Spitze des Lichtgriffels auftrifft. Da diese Zeitinformation herangezogen werden kann, um die Zustände der zugehörigen Zeilen- und Spaltenablenkung des Monitor-Elektronenstrahls abzufragen, ist es möglich, die x-/y-Koordinaten des Monitor-Elektronenstrahl zu erkennen. Die von dem Mikrocomputer 8 ermittelten x-/y-Koordinaten des Aufsetzpunkts des Monitor-Elektronenstrahls, die dem Soll-Wert der Position des Elektronenstrahls 5 entsprechen, werden im Speicher 7 oder im Mikrocomputer 8 selbst abgespeichert.

Mit Hilfe des Lichtgriffels 14 können auf diese Weise nacheinander mehrere Positionen eingegeben und abgespeichert werden, etwa gemäß dem in der Fig. 2 angegebenen Muster. Zusätzlich zu den Soll-Positionen $P_1$ ... $P_8$, die stellvertretend für weitaus mehr Soll-Positionen — z.B. vierundsechzig — angegeben sind, können auch noch durch eine in der Fig. 3 nicht dargestellte Vorrichtung die Verweilzeiten $t_{v1}$ ... $t_{v8}$ eingegeben werden, die den jeweiligen Soll-Positionen zugeordnet sind.

Die Eingabe dieser Verweilzeiten geschieht beispielsweise dadurch, daß mittels einer Tastatur am Mikrocomputer 8 die jeweilige Verweilzeit eingestellt wird und dann, wenn die Spitze des Lichtgriffels 14 den Bildschirm 12 berührt, eine "Enter"-Taste gedrückt wird.

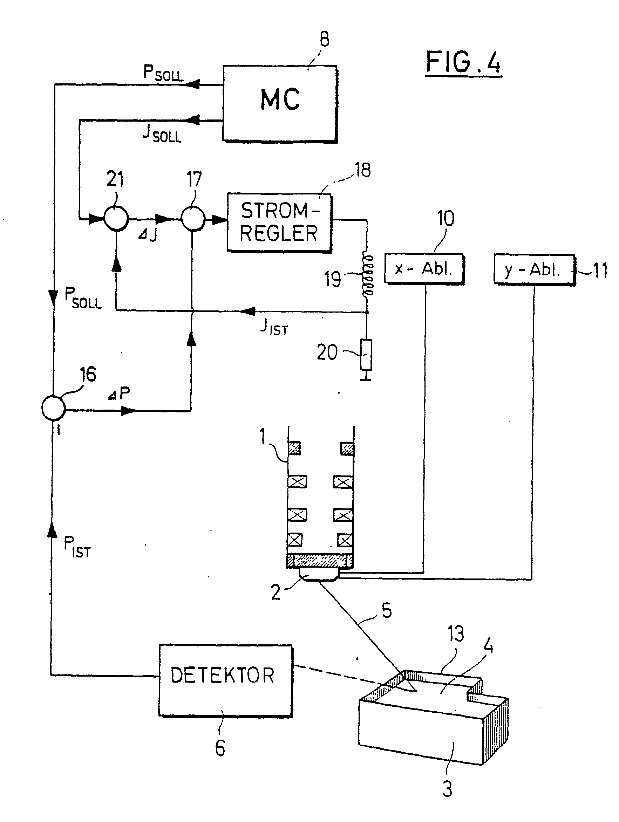

Wenn die Soll-Positionen $P_1$ ... $P_8$ mit den zugehörigen Verweilzeiten $t_{v1}$ ... $t_{v8}$ abgespeichert sind, kann der Elektronenstrahl 5 über einen Mikrocomputer 8, über die x/y-Ablenkung 10, 11 und über das Ablenksystem 2 in die vorgegebenen Positionen gesteuert werden. Um eine genaue Ansteuerung der Soll-Positionen zu erreichen, wird die Ist-Position des Elektronenstrahls 5 durch den Detektor 6 erfaßt und in einen Speicher 7 oder direkt in den Mikrocomputer 8 eingegeben. Mit Hilfe einer Regelschaltung wird der Elektronenstrahl von seiner Ist-Position in die Soll-Position gebracht. Eine solche Regelschaltung ist in der Fig. 4 gezeigt, und zwar nur für die x-Positionsregelung. Die y-Positionsregelung geschieht auf entsprechende Weise. In der Fig. 4 sind der Monitor 9 und der Speicher 7 weggelassen, da sie zum Verständnis der Regelschaltung nicht erforderlich sind.

Man erkennt aus dieser Darstellung, daß der Detektor 6 den Positionsistwert $P_{Ist}$ des Auftreffpunkts des Elektronenstrahls 5 auf das Targetmaterial 4 auf eine Subtrahierstelle 16 gibt, wo dieser Istwert $P_{Ist}$ von dem Positionssollwert $P_{soll}$, der vom Mikrocomputer 8 auf die Subtrahierstelle 16 gegeben wird, abgezogen wird. Die Abweichung ΔP zwischen Positions-Istwert und Positions-Sollwert wird auf eine Addierstelle 17 gegeben, deren Ausgangssignal auf einen Stromregler 18 gelangt, der über eine Spule 19 und Widerstand 20 die x-Ablenkung 10 beeinflußt.

Der Istwert $I_{ist}$ des Stroms, der durch die Spule 19 fließt, wird auf eine Subtrahierstelle 21 gegeben, wo er von dem Strom-Sollwert $I_{soll}$, der vom Mikrocomputer 8 vorgegeben wird, subtrahiert wird. Abweichung ΔI wird sodann auf die Addierstelle 17 gegeben und das Ausgangssignal dieser Addierstelle dem Stromregler 18 zugeführt.

Der Mikrocomputer 8 speichert somit u.a. zwei verschiedene Arten von Sollwerten ab: zum einen eine bestimmte Anzahl von Punkten als Stromwerte und zum anderen dieselbe Anzahl von Punkten als x/y-Ortskoordinaten-Werte.

Zunächst ist für die Positionierung des Elektronenstrahls 5 nur der Sollwert $I_{soll}$ maßgebend, da noch keine Positions-Istwerte bzw.-Sollwerte vorliegen. Erst wenn diese gegeben sind, werden ΔI und ΔP zur Korrektur herangezogen.

**Patentansprüche**

1. Einrichtung, bei der ein Elektronenstrahl auf ein Medium trifft, das sich in einem Tiegel befindet, wobei die Konturen des Tiegels auf einem Bildschirm abgebildet sind, dadurch gekennzeichnet, daß für die Festlegung eines oder mehrerer Positionssollwerte für die Auftreffpunkte ($P_1 \ldots P_8$) des Elektronenstrahls (5) innerhalb der Konturen (13) des Tiegels (3) ein Lichtgriffel (14) vorgesehen ist.

2. Einrichtung nach Anspruch 1, dadurch gekennzeichnet, daß eine Einrichtung vorgesehen ist, welche die Festlegung der Verweildauer ($t_{v1} \ldots t_{v8}$) des Elektronenstrahls an den jeweiligen Soll-Positionen ($P_1 \ldots P_8$) ermöglicht.

3. Einrichtung nach Anspruch 1, dadurch gekennzeichnet, daß ein mit dem Bildschirm verbundener Speicher (7 oder 8) vorgesehen ist, in dem die Konturen (13) des Tiegels (3) abgespeichert sind.

4. Einrichtung nach Anspruch 1, dadurch gekennzeichnet, daß eine Einrichtung (6) für die Erfassung der Ist-Position des Auftreffpunkts des Elektronenstrahls (5) vorgesehen ist.

5. Einrichtung nach Anspruch 1, dadurch gekennzeichnet, daß eine Ablenkeinheit (2, 10, 11) vorgesehen ist, welche mit Hilfe magnetischer oder elektrischer Felder den Auftreffpunkt des Elektronenstrahls (5) auf dem Medium (4) einstellen kann.

6. Einrichtung nach Anspruch 1, dadurch gekennzeichnet, daß die jeweilige Ist-Position des Elektronenstrahls (5) auf dem Bildschirm (12) dargestellt ist.

7. Einrichtung nach Anspruch 3, dadurch gekennzeichnet, daß die Konturen (13) des Tiegels (3) mittels des Teach-In-Verfahrens ermittelt werden.

8. Einrichtung nach Anspruch 3, dadurch gekennzeichnet, daß bei der Erfassung der Konturen eines Rechtecktiegels der Elektronenstrahl (5) manuell in die Tiegelecken gelenkt wird und eine Recheneinrichtung (8) durch lineare Interpolation zwischen den einzelnen Eckpositionen die Gesamtkontur ermittelt.

9. Einrichtung nach Anspruch 5, dadurch gekennzeichnet, daß der Elektronenstrahl (5) durch unmittelbare Vorgabe einer x,y-Soll-Position, die durch entsprechende Ablenkströme des Ablenksystems (2, 10, 11) dargestellt wird, direkt und wenigstens angenähert in eine Soll-Position gesteuert wird.

10. Einrichtung nach Anspruch 9, dadurch gekennzeichnet, daß der Elektronenstrahl (5), nachdem er auf direktem Weg in die x,y-Position gebracht wurde, mit Hilfe einer Regeleinrichtung in die exakte x,y-Soll-Position gebracht wird, wobei die von einem Istwert-Geber (6) gelieferten Signale mit dem Soll-Wert verglichen werden und der Elektronenstrahl (5) von der Position x', y' in die Position x, y geführt wird.

11. Einrichtung nach Anspruch 1, dadurch gekennzeichnet, daß mehrere Auftreffpunkte ($P_1 \ldots P_8$) des Elektronenstrahls (5) als Soll-Werte abgespeichert sind und daß diese Auftreffpunkte ($P_1 \ldots P_8$) nacheinander von dem Elektronenstrahl angesteuert werden, wobei für die Ansteuerung aller Punkte die Zeit T erforderlich ist.

12. Einrichtung nach einem oder mehreren der vorangegangenen Ansprüche, dadurch gekennzeichnet, daß nach der Eingabe der Sollpositionen ($P_1 \ldots P_8$) mit der jeweils zugeordneten Verweildauer ($t_{v1} \ldots t_{v8}$) die Sollposition zunächst mit $10^4 \ t_{v1} \ldots t_{v8}$ durchlaufen werden, wobei die den Ortskoordinaten (x, y) der Sollpositionen ($P_1 \ldots P_8$) zugeordneten Stromwerte einer magnetischen Ablenkeinheit (2, 10, 11) korrigiert werden.

13. Einrichtung nach Anspruch 12, dadurch gekennzeichnet, daß nach Beendigung des ersten Korrekturvorgangs der Positionsdurchlauf (16) mit der Verweildauer $10^3 \ t_{v1} \ldots t_{v8}$ erfolgt.

14. Einrichtung nach Anspruch 13, dadurch gekennzeichnet, daß nach Beendigung des zweiten Korrekturvorgangs der Positionsdurchlauf (16) mit der jeweiligen Verweildauer $10^2 \ t_{v1} \ldots t_{v8}$ erfaßt.

**Revendications**

1. Dispositif de bombardement d'un milieu se trouvant dans un creuset, les contours du creuset étant représentés sur un écran d'affichage, caractérisé en ce qu'un photostyle (14) est prévu pour déterminer une ou plusieurs valeurs de consigne de position pour les points d'impact ($P_1 \ldots P_8$) du faisceau d'électrons (5) à l'intérieur des contours (13) du creuset (3).

2. Dispositif selon la revendication 1, caractérisé en ce qu'il est prévu un dispositif permettant de déterminer le temps de séjour ($t_{v1} \ldots t_{v8}$) du faisceau d'électrons en chaque position de consigne ($P_1 \ldots P_8$).

3. Dispositif selon la revendication 1, caractérisé en ce qu'il est prévu une mémoire (7 ou 8) reliée à l'écran d'affichage, dans laquelle sont emmagasinés les contours (13) du creuset (3).

4. Dispositif selon la revendication 1, caractérisé en ce qu'il est prévu un dispositif (6) destiné à mesurer la position réelle du point d'impact du faisceau d'électrons (5).

5. Dispositif selon la revendication 1, caractérisé en ce qu'il est prévu une unité de déviation (2, 10, 11) pouvant régler au moyen de champs magnétiques ou électriques le point d'impact du faisceau d'électrons (5) sur le milieu (4).

6. Dispositif selon la revendication 1, caractérisé en ce que la position réelle respective du faisceau d'électrons (5) est représentée sur l'écran d'affichage (12).

7. Dispositif selon la revendication 3, caractérisé en ce que les contours (13) du creuset (3) sont déterminés au moyen du procédé par apprentissage.

8. Dispositif selon la revendication 3, caractérisé en ce que, lors de la mesure des contours d'un creuset rectangulaire, le faisceau d'électrons (5) est dirigé manuellement dans les coins et qu'un dispositif de calcul (8) détermine le contour global par interpolation linéaire entre les positions de coin individuelles.

9. Dispositif selon la revendication 5, caractérisé en ce que le faisceau d'électrons (5) est commandé, directement ou au moins de manière approchée, en une position de consigne, par allocation directe d'une position de consigne en x, y, qui est représentée par des courants de déviation correspondants du système de déviation (2, 10, 11).

10. Dispositif selon la revendication 9, caractérisé en ce qu'après avoir été placé par cheminement direct dans la position en x, y, le faisceau d'électrons (5) est placé dans la position de consigne en x, y exacte à l'aide d'un dispositif de réglage, les signaux délivrés par un transmetteur de valeur réelle (6) étant comparés à la valeur de consigne et le faisceau d'électrons (5) étant guidé de la position x', y' à la position x, y.

11. Dispositif selon la revendication 1, caractérisé en ce que plusieurs points d'impact ($P_1 \ldots P_8$) du faisceau d'électrons (5) sont mis en mémoire comme valeurs de consigne et que ces points d'impact ($P_1 \ldots P_8$) sont commandés les uns après les autres par le faisceau d'électrons, le temps T étant nécessaire pour la commande de tous les points.

12. Dispositif selon une ou plusieurs des revendications précédentes, caractérisé en ce qu'après introduction des valeurs de consigne ($P_1 \ldots P_8$), on parcourt tout d'abord avec $10^4$ $t_{v1} \ldots t_{v8}$ les positions de consigne, avec le temps de séjour associé ($t_{v1} \ldots t_{v8}$), les valeurs de courant d'une unité de déviation magnétique (2, 10, 11) associées aux coordonnées locales (x, y) des positions de consigne ($P_1 \ldots P_8$) faisant l'objet d'une correction.

13. Dispositif selon la revendication 12, caractérisé en ce que le parcours des positions (16) selon le temps de séjour $10^3$ $t_{v1} \ldots t_{v8}$ s'effectue après achèvement du premier processus de correction.

14. Dispositif selon la revendication 13, caractérisé en ce que le parcours des positions (16) selon le temps de séjour respectif $10^2$ $t_{v1} \ldots t_{v8}$ s'effectue après achèvement du deuxième processus de correction.

**Claims**

1. Device for the bombardment of a medium which is located in a crucible with an electronic beam, whereby the contours of the crucible are shown on a screen, characterised in that a light pen (14) is provided for the establishment of one or several nominal position values of the impact points ($P_1 \ldots P_8$) of the electron beam (5) within the contours (13) of the crucible (3).

2. Device according to claim 1, characterised in that a device is provided which makes possible the establishment of the tarrying time ($t_{v1} \ldots t_{v8}$) of the electron beam at the respective nominal positions ($P_1 \ldots P_8$).

3. Device according to claim 1, characterised in that a memory (7 or 8) which is coupled to the screen and in which the contours (13) of the crucible (3) are stored, is provided.

4. Device according to claim 1, characterised in that a device (6) for the detection of the actual position of impact of the electron beam (5) is provided.

5. Device according to claim 1, characterised in that a deflector unit (2, 10, 11) is provided which can set the point of impact of the electron beam (5) on the medium (4) by means of magnetic or electrical fields.

6. Device according to claim 1, characterised in that the respective actual position of the electron beam (5) is displayed on the screen (12).

7. Device according to claim 3, characterised in that the contours (13) of the crucible (3) are detected by way of the teach-in-process.

8. Device according to claim 3, characterised in that with the detection of the contours of a right-angled crucible, the electron beam (5) is manually guided into the crucible corners, and a computing device (8) establishes the entire contour by way of linear interpolation between the individual corner positions.

9. Device according to claim 5, characterised in that the electron beam (5) is guided directly and at least near to a nominal position by way of direct input of an x, y-nominal position which are represented by respective deflector currents of the deflector system (2, 10, 11).

10. Device according to claim 9, characterised in that the electron beam (5), after having been placed directly in the x, y position, is directed by way of a control device into the exact x, y-nominal position whereby the signals of an actual-value indicator (6) are compared with the nominal value, and the electron beam (5) is directed from position x', y' into position x, y.

11. Device according to claim 1, characterised in that several impact points ($P_1 \ldots P_8$) of the electron beam (5) are stored as nominal values, and that these impact points ($P_1 \ldots P_8$) are

approached one after the other by the electron beam whereby the time T is required for the approach to all points.

12. Device according to one or several of the above claims, characterised in that after the input of the nominal positions ($P_1 \ldots P_8$) with the respective assigned tarrying time ($t_{v1} \ldots t_{v8}$), the nominal positions are initially run through with $10^4 \, t_{v1} \ldots t_{v8}$ whereby the current values relative to the location coordinates (x, y) of the nominal positions ($P_1 \ldots P_8$) of a magnetic deflector unit (2, 10, 11) are corrected.

13. Device according to claim 12, characterised in that after completion of the first correction phase, the position run (16) takes place with a tarrying time of $10^3 \, t_{v1} \ldots t_{v8}$.

14. Device according to claim 13, characterised in that after completion of the second correction phase, the position run (16) is within the respective tarrying time of $10^2 \, t_{v1} \ldots t_{v8}$.

**EP 0 222 219 B1**

FIG.1

FIG.2

FIG.3

EP 0 222 219 B1

FIG.4